# EUROPEAN PATENT APPLICATION

(11) **EP 1 975 926 A2**
(43) Date of publication of application: **01.10.2008**
(21) Application number: 08251147.8
(22) Date of filing: 28.03.2008
(51) Int. Cl.: G11B 5/72

(54) **Method of and apparatus for monitoring flow of lubricant vapor forming lubricant coatings of magnetic disks**

(30) Priority: 29.03.2007 US 693424
(71) Applicant: INTEVAC, INC., Santa Clara, California 95054-2704 (US)
(72) Inventor: Petersen, Carl, Fremont, CA (US); Ames, Kenneth, San Jose, CA 95123 (US)
(74) Representative: Foster, Mark Charles

(57) **Abstract**

Lubricant coatings are applied as lubricant vapor to magnetic disks 18 in a lubricant vapor flow path between the disks and a reservoir 24 for liquid lubricant that is heated to the vapor. The flow path includes a vapor chamber between the reservoir and an apertured diffuser 30. Plural piezoelectric crystals selectively, at different times, monitor the flow rate of lubricant vapor flowing in the vapor chamber, a result achieved by selectively positioning a shutter 28 that is selectively opened and closed between the vapor flowing in the vapor chamber and the crystals. Temperature variations of the crystals are compensated by a feedback arrangement for maintaining the crystal temperature constant.

## Description

### Field of the Invention

The present invention relates generally to a method of and apparatus for monitoring the mass flow rate of lubricant vapor flowing through a vapor volume toward a vacuum chamber in which hard magnetic disks to be coated by the lubricant vapor can be located.

### Background Art

Hughes et al., United States Patent 6,183,831 (incorporated by reference herein), discloses a method of and apparatus for coating hard magnetic disks with a lubricant film by applying the lubricant (preferably a perfluoropolyether (PFPE) disclosed in US patent 5,776,577) in vapor, that is gaseous, form to a magnetic layer on the disks in a vacuum chamber. The magnetic disks are sequentially loaded into a flow path of the vapor by a carrying blade that lifts the disks out of cassettes that are transported into and out of the vacuum chamber. The vapor is obtained by supplying sufficient heat to a liquid form of the lubricant in a source located in the vacuum chamber. The resulting vapor flows through a gas diffuser plate prior to being incident on the magnetic disk. A single quartz crystal microbalance (QCM) is included in a gauge for monitoring the flow rate of the lubricant vapor being evaporated from the liquid lubricant source to control the amount of heat applied to the liquid lubricant source and thereby control the temperature of the liquid lubricant and the mass flow rate of vapor lubricant evaporated from the liquid lubricant source. The quartz crystal microbalance is a very sensitive piezoelectric crystal connected to an oscillator. The resonant frequency of the crystal determines the frequency of the oscillator. The oscillator frequency is detected to provide a measure of the vapor lubricant mass flow rate.

The foregoing arrangement described in the Hughes et al. patent has performed satisfactorily, but can be improved. The piezoelectric crystals have a limited lifetime that is shortened due to the constant exposure of the crystals to the vapor, even during prolonged idle or lull periods while no processing of hard magnetic disks occurs. During such idle periods vapor continuously flows from the liquid lubricant source into the vacuum chamber where the hard magnetic disks are located during processing because of the instabilities associated with starting the flow of the lubricant vapor. As a result of the limited lifetimes of the piezoelectric crystals, it is necessary to somewhat frequently replace the crystals, causing a stoppage in the operation of the described manufacturing arrangement of which the crystals are apart. Such a stoppage is inefficient and costly.

It is, accordingly, an object of embodiments of the present invention to provide a new and improved method of and apparatus for monitoring mass flow rate of lubricant vapor forming lubricant coatings on hard magnetic disks.

Another object of embodiments of the present invention is to provide a new and improved method of and apparatus for monitoring mass flow rate of lubricant vapor forming lubricant coatings on hard magnetic disks, wherein the length of time between replacement of mass flow rate monitors is extended compared to that of the typical prior art arrangement.

An additional object of embodiments of the invention is to provide a new and improved method of and apparatus for monitoring mass flow rate of lubricant vapor forming lubricant coatings on hard magnetic disks, wherein there is an arrangement of mass flow rate monitors that promotes the inexpensive and efficient operation of manufacturing equipment for applying the lubricant coatings to the hard magnetic disks.

### Summary of the Invention

In accordance with one aspect of the invention, apparatus is a provided for applying lubricant coatings to magnetic disks selectively held in place on a holder in a vacuum chamber while vapor that can form the lubricant coatings is applied to one of the disks while the disc is held in place on the holder. The apparatus comprises a reservoir for liquid that can be vaporized to form the vapor and a heater for heating the liquid in the reservoir to a lubricant vapor. A flow path for the flow of the lubricant vapor from the reservoir to the disk while the disk is in place on the holder is provided. The flow path includes (1) an apertured diffuser between the reservoir and the holder while the disc is in place in the flow path, and (2) a vapor chamber between the reservoir and the apertured diffuser. The flow path is arranged to be in a vacuum condition while liquid in the reservoir is heated to a lubricant vapor. Plural monitors detect the flow rate of lubricant vapor flowing in the flow path.

Preferably, a shutter arrangement controls the flow of lubricant vapor to the monitors. The shutter arrangement causes: (a) during a first particular time interval, a first of the monitors to be responsive to the flow rate of lubricant vapor flowing in the vapor chamber while the remaining monitor(s) is unresponsive to the flow rate of lubricant vapor flowing in the vapor chamber, and (b) during a second particular time interval, the second monitor is responsive to the flow rate of liquid vapor flowing in the vapor chamber while the remaining monitor(s) is unresponsive to the flow rate of liquid vapor flowing in the vapor chamber.

The shutter arrangement is also preferably arranged for causing all the monitors to be unresponsive to the flow rate of liquid vapor flowing in the vapor chamber during a third particular time.

The vapor chamber may include a wall extending in the same direction as a straight-line flow path from the reservoir to the apertured diffuser. Preferably, the wall includes a plurality of apertures, one for each of the monitors, for providing a separate flow path for the lubricant vapor between the vapor chamber and each monitor. The shutter arrangement is between the plurality of apertures in the wall of the vapor chamber and the monitors.

The shutter arrangement is preferably arranged for causing all the monitors to be unresponsive to the flow rate of liquid vapor flowing in the vapor chamber during a third particular time interval.

In a preferred embodiment, each of the monitors includes a piezoelectric crystal having a resonant frequency affected by the flow of vapor in the flow path. A switching arrangement between the monitors and a variable frequency oscillator and the shutter is arranged so that the piezoelectric crystal of an operative monitor responsive to the flow of vapor in the flow path is connected to the oscillator to the exclusion of piezoelectric crystal(s) of the remaining monitor(s), to thereby affect the oscillator frequency.

We have observed that the oscillator output frequency does not appear to accurately track the mass flow rate after the monitors have been operating for a while. We have discovered this inaccuracy occurs because the piezoelectric crystal temperature increases after the monitors have been operating for a while. The change in crystal temperature affects the frequency generated by the oscillator. The tendency of the crystal resonant frequency to change as a function of the crystal temperature is overcome by detecting crystal temperature and by providing a controller responsive to the detected temperature. The controller preferably includes a temperature control feedback arrangement for maintaining the crystal temperature constant. Alternatively, the controller can include a lookup table for correlating crystal temperature and crystal resonant frequency. Such a lookup table has first and second inputs respectively responsive to the detected crystal temperature and the output of a frequency detector for the oscillator operation frequency. It is therefore a further object of the present invention is to provide an object of the present invention to provide a new and improved method of and apparatus for monitoring mass flow rate of lubricant vapor forming lubricant coatings on hard magnetic disks, wherein inaccuracies in a measure of mass flow rate that has been observed after the apparatus has been in use for a while is overcome.

The above and still further objects, features and advantages of the present invention will become apparent upon consideration of the following detailed description of a specific embodiment thereof provided by way of example, especially when taken in conjunction with the accompanying drawings.

### Brief Description of the Drawings

Figure 1 is a top view, partially in section, of a preferred embodiment of a vapor source in accordance with the present invention, in combination with a schematic showing of a chamber holding a hard magnetic disk to be coated;
Figure 2 is a partial side view, partially in section, of the structure illustrated in Figure 1, taken through the line 2--2;
Figure 3 is a partial side view, partially in section, of the structure illustrated in Figure 1, taken through the line 3--3;
Figure 4 is a front view of the structure illustrated in Figure 1, taken through the line 4--4; and
Figure 5 is a diagram of feedback control circuitry for the temperature of surfaces of the vapor source of Figures 1-4.

### Detailed Description of the Drawings

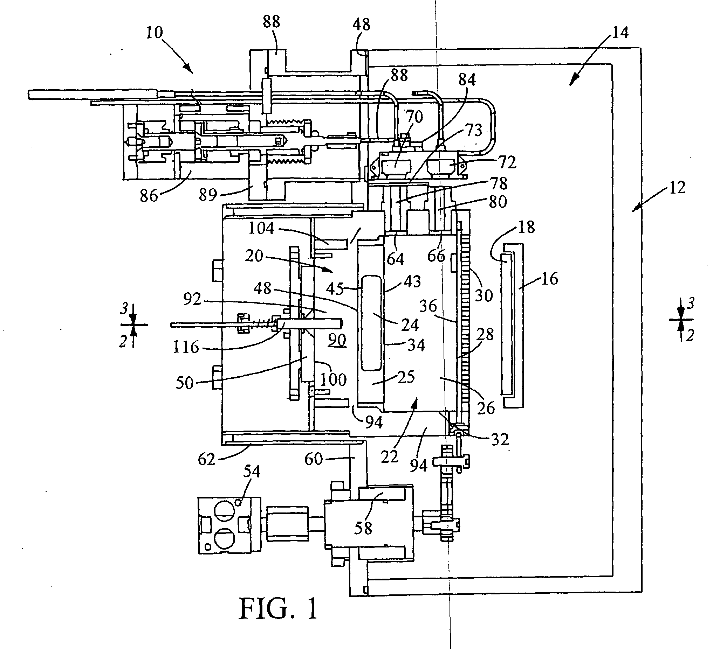

Reference is now made to the drawings that includes lubricant (frequently referred to as lube) source 10 and housing 12 including vacuum chamber 14 that is maintained by a suitable vacuum pump (not shown) at a suitable vacuum pressure. Located in chamber 14 is holder 16 for hard magnetic disk 18 that includes a substrate layer overlaid by a chromium layer, in turn overlaid by a magnetic layer, as disclosed in the aforementioned patents. Holder 16 sequentially lifts different hard magnetic disks from cassettes that are sequentially moved into and out of vacuum chamber 14 so that the disks are brought to the position illustrated In Figures 1-3, in the path of the lubricant vapor that is deposited on the disks. The lubricant is preferably PFPE.

Source 10 includes an atmospheric portion 20, maintained at atmospheric pressure, and a vacuum portion 22, maintained at approximately the same vacuum pressure as the vacuum in chamber 14 by virtue of a gas flow path that frequently exists between vacuum portion 22 and chamber 14. Liquid lube reservoir 24, that is carried by housing 25, is in vacuum portion 22 as are (1) vapor volume 26, (2) selectively opened and closed diffuser shutter 28 and (3) diffuser plate 30.

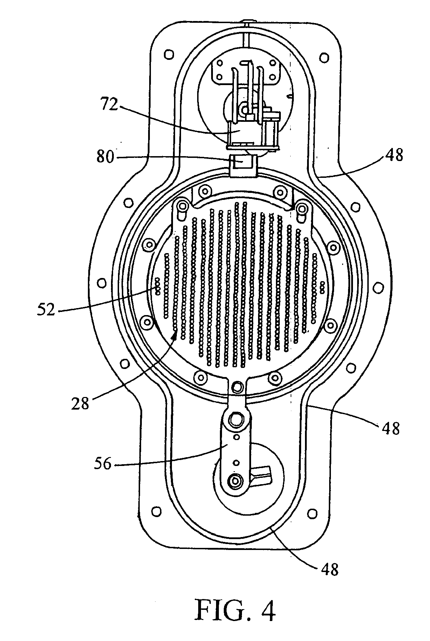

Vapor volume 26 is a cavity having a cylindrical sidewall 32 extending at right angles to planar faces 34 and 36 that are parallel to each other and define boundaries of the vapor volume. One face of reservoir 24 occupies a substantial portion of face 34, and a first planar face of diffuser shutter 28 (Figure 4) occupies a substantial portion of face 36. A second planar face of diffuser shutter 28, parallel to the first face of the diffuser shutter, abuts a first planar face of diffuser plate 30.

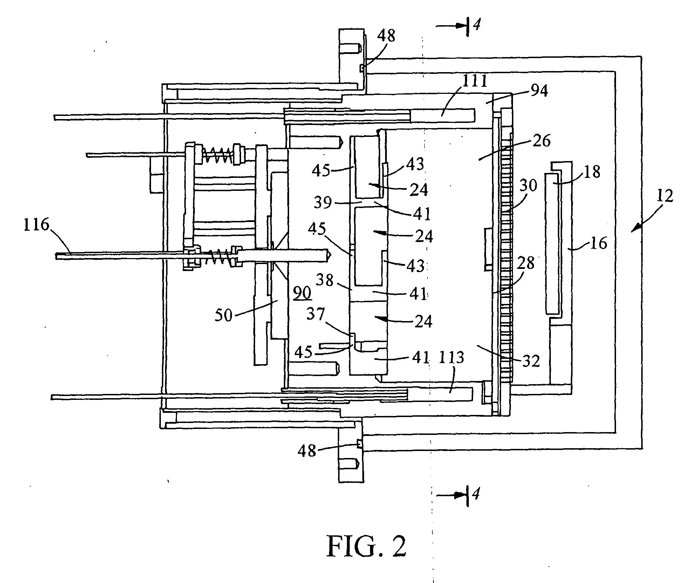

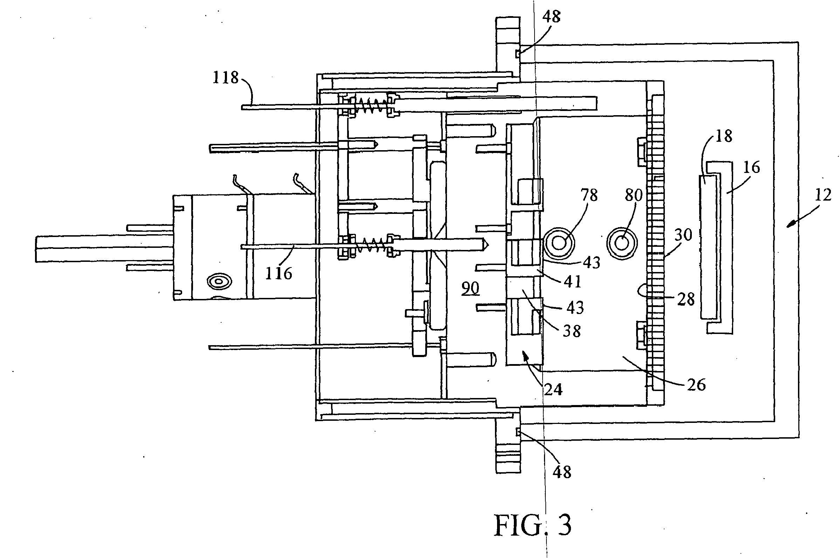

As illustrated in Figures 2 and 3, housing 25 is arranged so liquid lube reservoir 24 includes three stacked segments 37, 38 and 39, each including a lube well formed by a floor 41 and a flange or lip 43, as well as a back wall 45. Liquid lube is loaded into the well of each of segments 37, 38 and 39 while source 10 is at atmospheric pressure, prior to the source being connected to housing 12. Vacuum seal (that is, gasket) 48 (Figures 1-4) between abutting walls of source 10 and housing 12 assists in maintaining the vacuum in vacuum chamber 14 and vacuum portion 22 of source 10.

The liquid lube in reservoir 24 is heated to a vapor by resistive heater coil 50 in atmospheric portion 20 of source 10. The vaporized lube flows from reservoir 24 into vapor volume 26, thence through open diffuser shutter 28 and diffuser plate 30 toward hard disk 18 and holder 16 while the holder has lifted the hard disk from a cassette to the position illustrated in Figures 1-3, in the path of the lube vapor flowing through shutter 28 and plate 30.

When diffuser shutter 28 is closed, as occurs during substantial idle or lull periods in the operation of source 10 while no hard magnetic disks are being processed, none of the apertures in the diffuser shutter and diffuser plate 30 are in registration so the vaporized lube quickly fills vapor volume 26. As a result of the vaporized lube filling vapor volume 26 while diffuser shutter 28 is closed, the pressure in the vapor volume increases sufficiently so that additional vapor is not evaporated from reservoir 24, even though the amount of heat applied to the liquid lube in reservoir 24 by heater coil 50 remains approximately constant. As a result, there is a minimum amount of wasted lube evaporated from reservoir 24 during the substantial idle or lull periods. By continuously applying heat to the liquid in reservoir 24, instabilities in the evaporation of liquid from reservoir 24 that have a tendency to occur as result of starting and stopping the heating process of the liquid lube in reservoir 24 are avoided.

Diffuser plate 30 includes many rows of closely spaced, relatively small circular openings (not shown) that are aligned and in register with corresponding openings 52 (Figure 4) in diffuser shutter 28 when the diffuser shutter is closed. There is one-to-one correspondence between each the openings of diffuser plate 30 and openings 52 of shutter 28. When diffuser shutter 28 is open, the diffuser shutter is shifted in position so that openings 52 are located between the rows of the small circular openings of stationary diffuser plate 30, to provide a flow path, through the openings of diffuser plate 30, for the lube vapor evaporated from reservoir 24. Diffuser shutter 28 selectively opens and closes the flow path of vapor from reservoir 24 to hard magnetic disk 18 as result of motor 54 driving rotary linkage 56. Motor 54 is connected to linkage 56 by way of gearbox 58, carried by flange 60 on housing 62 of source 10; linkage 56 is connected between diffuser shutter 28 and gearbox 58 so that the shutter turns a few degrees in response to rotation of the shaft of motor 54. Diffuser plate 30 and the openings thereof, and shutter 28 and openings 52 thereof, as well as linkage 56, are such that all the openings in diffuser 30 are simultaneously unblocked and simultaneously blocked, by shutter 28 and openings 52 as the shutter is opened and closed. Consequently, the lube coating applied to the magnetic layer of disk 18 has a substantially uniform thickness.

Piezoelectric crystals 70 and 72 (both located in housing 71) selectively monitor the deposition rate of vapor lube flowing through vapor volume 26, such that during a first time interval crystal 70 is coupled to vapor volume 26 to the exclusion of crystal 72, and during a second time interval crystal 72 is coupled to the vapor volume to the exclusion of crystal 70. During a third time interval, neither crystal 70 nor crystal 72 is coupled to the vapor volume. During the first and second intervals, particles of lube vapor in vapor volume 26 are incident on crystals 70 and 72. During the third interval, no vapor lube particles are incident on the crystals.

Shutter 73 is selectively interposed in fluid flow paths between volume 26 and crystals 70 and 72 to achieve these results. Shutter 73 reduces the exposure time of crystals 70 and 72 to the lube vapor during lull or idle periods to reduce maintenance expenses by prolonging the useful life of the crystals. The use of plural deposition rate monitoring crystals 70 and 72, rather than a single deposition rate monitoring crystal, helps to achieve the same beneficial result.

To these ends, sidewall 32 of vapor volume 26 includes aligned openings 74 and 76 that are displaced from each other along the length of the wall between reservoir 24 and diffuser shutter 28. Openings 74 and 76 are respectively in fluid flow relationship with cylindrical passages 78 and 80 having outlet apertures respectively in close proximity to piezoelectric crystals 70 and 72, preferably of the QCM type that is available from Maxteck Inc. of Beaverton Oregon. Rotary shutter 73 is in the form of a rotatable disk driven by shaft 84, in turn driven by pneumatic motor 86 and linkage 88 so shutter 73 is selectively located between the outlet apertures of passages 78 and 80 and crystals 70 and 72. Motor 86 is in the atmosphere and is carried by housing 89 that is connected to flange 60. Crystals 70 and 72, shutter 73, shaft 84 and a portion of linkage 88 are in the vacuum of chamber 14, while motor 86, housing 89 and the remainder of linkage 88 are at atmospheric pressure.

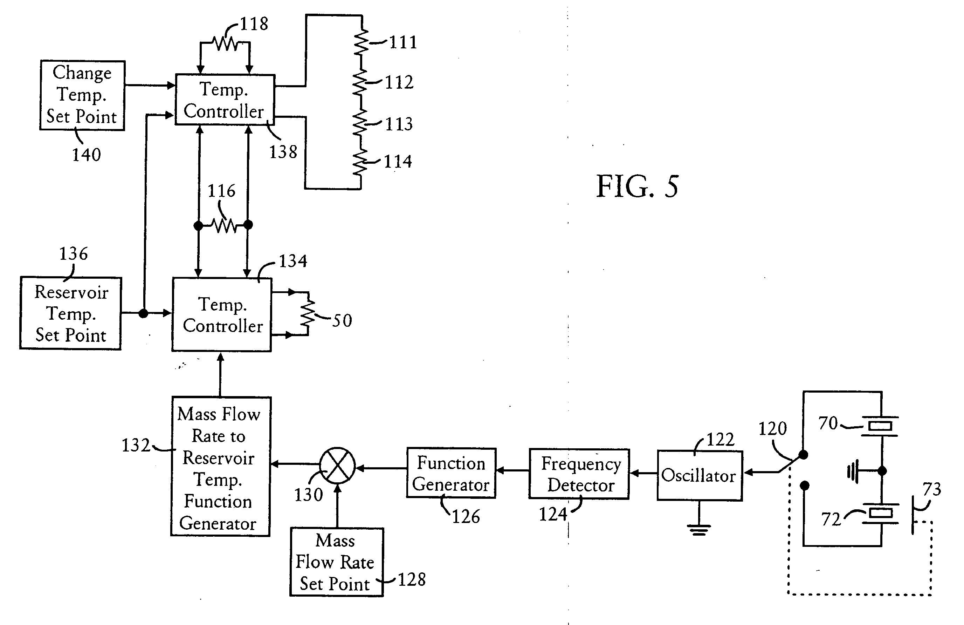

Housing 71 for crystals 70 and 72 progressively heats up to the temperature of process chamber 14 after chamber 14 has been in operation for a while. However, initial calibration of the deposition rate detected by crystals 70 and 72 and indicated by the frequency derived by oscillator 122 (Fig. 5), as detected by frequency detector 124, is usually done at the beginning of a production cycle. As such, the resonant frequency of crystal 70 or 72 may not represent the true deposition rate during full production cycles when the entire toll of Figs. 1-4 is in a dynamic thermal stead state.

To mitigate this potential vulnerability in control of vapor flow rate, the temperatures of crystals 70 and 72 are actively controlled by controlling the temperature of housing 71 so it is constant. To this end a cooling mechanism is included in housing 71 to maintain crystals 70 and 72 at a constant temperature so the reading derived from crystals 70 and 72 is always with reference to a constant temperature of fluid coolant (air or water as appropriate). The coolant fluid flows to and from housing 71 by tubes 75, 77 and 79 such that the coolant fluid in tubes 77 and 79 respectively provide primary cooling to crystals 70 and 72. The heated coolant flowing through tube 79 flows back to heat exchanger 81, where it is cooled and recirculated back to tubes 77 and 79. The amount of cooling imparted by heat exchange 81 to the recirculated coolant fluid is controlled by temperature detector 83 that is imbedded in housing 71 to effectively monitor the temperature of crystals 70 and 72. Detector 83 is electronically connected by a suitable cable (not shown) to the heat exchanger.

Cylindrical sidewall 32 of vapor volume 26 is part of heater block 90, having a high thermal conductivity, made preferably of copper or some other relatively inexpensive, high thermal conductivity metal that aids in reducing condensation of vapor lube on block 90. Because block 90 is made of a high thermal conductivity material the entire length of each wall of block 90 is at a substantially uniform temperature so differential condensation of vapor on the same wall surfaces of block 90 is minimized.

Block 90 includes circular base 92 that provides a high thermal conductivity path for heat from resistive heating coil 50 to the liquid in reservoir 24. Block 90 includes heat choke 94. Heat choke 94 is a portion of block having a high thermal impedance compared to the rest of block 90. Heat choke 94 is a circular groove 102 between base 92 and circular flange 96, the inner periphery of which forms cylindrical sidewall 32 of vapor volume 26 to enable block 90 to have two thermal zones, one formed by base 92 and a second formed by flange 96. Block 90, in combination with resistive heating elements and a temperature detector arrangement, causes sidewall 32 of vapor volume 26 to be at a predetermined temperature, such as 5°C, above the temperature of base 92 of block 90 that provides the high thermal conductivity path for heat from resistive heating coil 50 to the liquid in reservoir 24. As a result, condensation of lube vapor in vapor volume 26 onto sidewall 32 is minimized, to provide more efficient operation of source 10.

Circular base 92 has a planar circular face 98 that is in vacuum portion 22 of source 10 and abuts a planar, circular face of housing 25 for reservoir 24. Face 98 is in a plane at right angles to a straight-line path from reservoir 24 to face 36 of diffuser shutter 28 from which extends annular flange or ring 96.

Base 92 includes a planar circular face 100 that is parallel to face 98. Resistive heating coil 50 includes a planar circular face that abuts face 100 to assist in providing the high thermal conductivity path between the resistive heating coil and reservoir 24.

Base 90 includes the deep annular groove 104 in face 100 that is in atmospheric portion 20 of source 10. Groove 102 extends from face 100 almost to face 102 to form a narrow neck (that constitutes heat choke 94) between base 92 and flange 94. Because of heat choke 94 it is possible, through the use of active temperature control, to maintain base 92 and flange 94 at different temperatures. The active temperature control is provided, inter alia, by embedding four mutually perpendicular resistive heating coils 111-114 in flange 94 in close proximity to wall 32. Only heating coils 111-113, that are diametrically opposite from each other, are illustrated in Figure 2.

Resistive temperature detectors 116 and 118 are respectively embedded in base 92 and flange 94 of block 90, to separately monitor the temperatures of the base and flange. Consequently, temperature detectors 116 and 118 effectively derive responses indicative of the temperatures of (1) the liquid lube in reservoir 24 and (2) wall 32 of vapor volume 26. A feedback controller of the type illustrated schematically in Figure 5 responds to resistive temperature detectors 116 and 118, as well as an indication of lube vapor flow rate in vapor volume 26, as detected by the operative one of piezoelectric crystals 70 or 72 to control the temperatures of base 92 and flange 94.

Reference is now made to the schematic diagram of Figure 5 for a feedback controller that responds to signals derived in response to the temperatures detected by resistive temperature detectors 116 and 118 and the mass flow rate detected by one of crystals 70 or 72 to control the currents supplied to resistive heating coil 50 that abuts base 92 of block 90 and series connected resistive heating coils 111-114 in flange 94 of block 90. One of crystals 78 or 80 is operative at a time, such that the operative crystal is connected by switch 120 to oscillator 122, to control the oscillator frequency. The contact position of switch 120 is synchronized with the position of shutter 73 so that: (1) in response to shutter 73 blocking crystal 72, switch 120 connects crystal 70 to the input of oscillator 122, (2) in response to shutter 73 blocking crystal 70, switch 120 connects crystal 72 to the input of oscillator 122, and (3) in response to shutter 73 blocking both crystals 70 and 72, the position of switch 120 does not change.

The frequency of oscillator 122 is determined by the resonant frequency of the crystal 70 or 72, connected by switch 120 to the oscillator. Consequently, the frequency of oscillator 122 is generally indicative of the mass flow rate of the lube vapor being detected by the active one of crystals 70 or 72, as determined by the position of shutter 73. Frequency detector 124 responds to the frequency generated by oscillator 122, to derive a DC voltage indicative of the frequency derived by oscillator 122. Function generator 126 responds to the DC voltage derived by detector 124 to derive a voltage indicative of the mass flow rate of the lube vapor detected by the active one of crystals 70 or 72.

The output signal of function generator 126 is compared in magnitude with the output signal of mass flow rate set point signal source 128 in subtractor 130 that derives an error signal indicative of the deviation between the desired mass flow rate of vapor lube in vapor volume 26 and the actual flow rate of the vapor lube in volume 26. The error output signal of subtractor 130 is applied to function generator 132 that converts the mass flow rate error signal to an error signal for the temperature of reservoir 24, that is, an error signal that is influential in controlling the amount of current supplied to resistive heating coil 50.

Temperature controller 134, for the amplitude of current that is supplied to resistive heating coil 50, responds to (1) the output signal of function generator 132, (2) signals derived from reservoir temperature set point source 136 and (3) the temperature sensed by resistive temperature detector 116. In essence, temperature controller 134 responds to the signals resulting from resistive temperature detector 116 and set point source 136 to determine the difference between the actual and desired temperatures of base 92 of block 90 to derive a temperature error signal. The temperature error signal is modified by the signal from function generator 132 to compensate for the error in the mass flow rate of the vapor lube flowing through volume 22. Temperature controller 134 responds to the modified error signal to control the current amplitude flowing through resistive heating coil 50 that in turn controls the temperature of base 92.

Temperature controller 138, for the amplitude of current flowing through series connected resistive heating coils 111-114 in flange 94, is responsive to signals derived in response to the temperatures detected by resistive temperature detectors 116 and 118, respectively in base 92 and flange 94 of block 90. In addition, temperature controller 138 responds to (1) the set point signal that source 136 derives for the temperature of reservoir 24, and (2) a set point signal that source 140 derives for the desired temperature difference between flange 94 and base 92. In essence, temperature controller 138 determines the temperature difference between base 92 and flange 94 by responding to the signals derived in response to the resistive changes of resistive temperature detectors 116 and 118. The temperature difference between base 92 and flange 94 is compared with the desired temperature difference between the base and flange, as derived by set point source 140 to derive an error signal indicative of the change in the amplitude of current supplied by temperature controller 138 to resistive heating coils 111-114. The error signal is combined with the output signal of reservoir temperature set point source 136 to control the actual amplitude of current supplied by temperature controller 138 to resistive heating coils 111-114.

While there has been described and illustrated a specific embodiment of the invention, it will be clear that variations in the details of the embodiment specifically illustrated and described may be made without departing from the true spirit and scope of the invention as defined in the appended claims.

## Claims

1. Apparatus for applying lubricant coatings to magnetic disks selectively held in place on a holder in a vacuum chamber while vapor that can form the lubricant coatings is applied to one of the disks while the disc is held in place on the holder, the apparatus comprising:
a reservoir for liquid that can be vaporized to form the vapor;
a heater for heating the liquid in the reservoir to a lubricant vapor;
a flow path for the flow of the lubricant vapor from the reservoir to the disk while the disk is in place on the holder; the flow path including (a) an apertured diffuser between the reservoir and the holder while the disc is in place in the flow path, and (b) a vapor chamber between the reservoir and the apertured diffuser; the flow path being arranged to be in a vacuum condition while liquid in the reservoir is heated to a lubricant vapor; and
plural monitors for the flow rate of lubricant vapor flowing in the flow path.

2. The apparatus of claim **1** further including a shutter arrangement for controlling the flow of lubricant vapor to the monitors, the shutter arrangement being arranged for causing: (a) during a first particular time, a first of the monitors to be responsive to the flow rate of lubricant vapor flowing in the vapor chamber while the remaining monitor(s) is unresponsive to the flow rate of lubricant vapor flowing in the vapor chamber, and (b) during a second particular time interval, the second monitor to be responsive to the flow rate of liquid vapor flowing in the vapor chamber while the remaining monitor(s) is unresponsive to the flow rate of liquid vapor flowing in the vapor chamber.

3. The apparatus of claim **2** wherein the shutter arrangement is arranged for causing all the monitors to be unresponsive to the flow rate of liquid vapor flowing in the vapor chamber during a third particular time interval.

4. The apparatus of claim **1,2 or 3** wherein the vapor chamber includes a wall extending in the same direction as a straight-line flow path from the reservoir to the apertured diffuser, the wall including a plurality of apertures, one for each of the monitors, for providing a separate flow path for the lubricant vapor between the vapor chamber and each of the monitors, a shutter arrangement between the plurality of apertures in the wall of the vapor chamber and the monitors, the shutter arrangement being arranged for causing, (a) at one particular time interval, the separate flow path to a first of the monitors to be open, and (b) the separate flow path to the remaining monitor(s) to be closed, and, during a second particular time interval, the separate flow path to the second monitor to be opened and the separate flow path to the remaining monitor(s) to be closed.

5. The apparatus of claim **1,2,3 or 4** wherein each of the monitors includes a piezoelectric crystal having a resonant frequency affected by the flow of vapor in the flow path, and the apparatus further including a variable frequency oscillator, and a switching arrangement between the monitors and the oscillator, the switching arrangement and the shutter being arranged so that the piezoelectric crystal of an operative monitor responsive to the flow of vapor in the flow path is connected to the oscillator to the exclusion of piezoelectric crystal(s) of the remaining monitor(s) so that the resonant frequency of the operative monitor affects the oscillator frequency.

6. The apparatus of claim 5 wherein the crystals have a tendency to change resonant frequency as a function of temperature, a detector arrangement for the crystal temperatures, and a control arrangement arranged to be responsive to the detector arrangement for over coming the tendency.

7. The apparatus of claim 6 wherein the control arrangement includes a feedback arrangement connected to be responsive to the temperature detector for maintaining the temperature of the crystals substantially constant.

8. A method of operating the apparatus of any one of claims 1 to 7 comprising: controlling the flow of lubricant vapor to the monitors so that during a first particular time interval a first of the monitors is responsive to the flow rate of lubricant vapor flowing in the flow path while the remaining monitor(s) is unresponsive to the flow rate of lubricant vapor flowing in the flow path, and during a second particular time interval the second monitor is responsive to the flow rate of lubricant vapor flowing in the flow path while the remaining monitor(s) is unresponsive to the flow rate of lubricant vapor flowing in the flow path.

9. The method of claim 8 further comprising preventing the flow of lubricant vapor to all of the plural monitors during a third particular time interval.

10. The method of claim 9 wherein the flow of lubricant is prevented during the first, second and third particular time intervals by positioning a closed shutter between the flow path and the monitors.

11. The method of claim 8 wherein the flow of lubricant is prevented during the first and second particular time intervals by positioning a closed shutter between the flow path and the monitors.

12. The method of claim 8,9,10 or 11 wherein each of the monitors includes a piezoelectric crystal having a resonant frequency affected by the flow of vapor in the flow path, and the apparatus further including a variable frequency oscillator, and a switching arrangement between the monitors and the oscillator, the method further comprising controlling the switching arrangement and the shutter so that the piezoelectric crystal of an operative monitor responsive to the flow of vapor in the flow path is connected to the oscillator to the exclusion of piezoelectric crystal(s) of the remaining monitor(s) so that the resonant frequency of the operative monitor affects the oscillator frequency.

13. The method of claim 12 wherein the crystals have a tendency to change resonant frequency as a function of temperature, the method further comprising detecting the crystal temperatures, and overcoming the tendency by responding to the detected crystal temperatures.

14. The method of claim 13 wherein the tendency is overcome by maintaining the temperature of the crystals substantially constant.

15. Apparatus for applying lubricant coatings to magnetic disks selectively held in place on a holder in a vacuum chamber while vapor that can form the lubricant coatings is applied to one of the disks while the disc is held in place on the holder, the apparatus comprising:
a reservoir for liquid that can be vaporized to form the vapor;
a heater for heating the liquid in the reservoir to a lubricant vapor;
a flow path for the flow of the lubricant vapor from the reservoir to the disk while the disk is in place on the holder; the flow path including(a) an apertured diffuser between the reservoir and the holder while the disc is in place in the flow path, and (b) a vapor chamber between the reservoir and the apertured diffuser; the flow path being arranged to be in a vacuum condition while liquid in the reservoir is heated to a lubricant vapor;
a monitor for the flow rate of lubricant vapor flowing in the flow path,
the monitor including a piezoelectric crystal having a resonant frequency affected by the flow of vapor in the flow path, the crystal being connected to a variable frequency oscillator so the crystal resonant frequency affects the frequency of the oscillator, the crystal having a tendency to change resonant frequency as a function of temperature, a detector arrangement for the crystal temperatures, and a control arrangement arranged to be responsive to the detector arrangement for over coming the tendency.

16. The apparatus of claim **15** wherein the control arrangement includes a feedback arrangement connected to be responsive to the temperature detector for maintaining the temperature of the crystal substantially constant.

17. A method of applying lubricant coatings to magnetic disks selectively held in place on a holder in a vacuum chamber while vapor that can form the lubricant coatings is applied to one of the disks while the disc is held in place on the holder, the method being performed with an apparatus comprising:
a reservoir for liquid that can be vaporized to form the vapor;
a heater for heating the liquid in the reservoir to a lubricant vapor;
a flow path for the flow of the lubricant vapor from the reservoir to the disk while the disk is in place on the holder; the flow path including (a) an apertured diffuser between the reservoir and the holder while the disc is in place in the flow path, and (b) a vapor chamber between the reservoir and the apertured diffuser; the flow path being in a vacuum condition while liquid in the reservoir is heated to a lubricant vapor,
a monitor for the flow rate of lubricant vapor flowing in the flow path,
the monitor including a piezoelectric crystal having a resonant frequency affected by the flow of vapor in the flow path, the piezoelectric crystal being connected to a variable frequency oscillator having a frequency affected by the crystal resonant frequency, the crystal having a tendency to change resonant frequency as a function of temperature, the method comprising detecting the crystal temperatures, and overcoming the tendency by responding to the detected crystal temperatures.

18. The method of claim **17** wherein the tendency is overcome by maintaining the temperature of the crystals substantially constant.
